# EUROPÄISCHE PATENTANMELDUNG

(11) **EP 1 978 791 A2**
(43) Veröffentlichungstag der Anmeldung: **08.10.2008**
(21) Anmeldenummer: 08006804.2
(22) Anmeldetag: 03.04.2008
(51) Int. Cl.: H05K 1/00, H01Q 1/32, B60R 16/02, H05K 3/12

(54) **Antenneneinrichtung für Fahrzeuge**

(30) Priorität: 04.04.2007 DE 102007016235
(71) Anmelder: Hirschmann Car Communication GmbH, 72654 Neckartenzlingen (DE)
(72) Erfinder: Petersen, Ingmar, 73733 Esslingen (DE); Schwarz, Bernd, 72141 Waldorfhäslach (DE); Pfletschinger, Markus, 72800 Eningen (DE)
(74) Vertreter: Thul, Hermann

(57) **Zusammenfassung**

Die Erfindung betrifft ein Verfahren zur Herstellung einer Antenneneinrichtung für Fahrzeuge, wobei eine Kunststofffolie mit einer elektrisch leitfähigen Paste bedruckt wird, um mit der gedruckten Paste Antennenstrukturen zu realisieren, wobei nach der Herstellung die Antenneneinrichtung in einen dafür vorgesehenen Einbauraum eines Fahrzeugbauteiles eingebaut wird, wobei erfindungsgemäß vorgesehen ist, dass die zunächst flächige Kunststofffolie aus einem verformbaren Material besteht und nach dem Bedrucken einer Umformung unterzogen wird, so dass die vorbereitete Kunststofffolie zusammen mit den Antennenstrukturen derart dauerhaft und plastisch verformt wird, dass nach dieser Verformung eine dreidimensional Form erreicht wird, die dem Einbauraum des Fahrzeugbauteiles entspricht.

## Beschreibung

Die Erfindung betrifft ein Verfahren zur Herstellung einer Antenneneinrichtung für Fahrzeuge gemäß den Merkmalen des Patentanspruches 1.

Die Antenneneinrichtung umfaßt zunächst zumindest einen flächigen Träger aus Kunststoff, zum Beispiel eine Kunststofffolie, auf dem elektrisch leitfähige Strukturen angeordnet sind, die als Strahler wirken und mit denen hochfrequente Signale empfangen und/oder gesendet werden können (Antennenstruktur).

Es ist schon aus der DE 10 2005 034 082.2 bekannt geworden, eine Kunststofffolie mit einer elektrisch leitfähigen Paste, zum Beispiel in einem Siebdruckverfahren zu bedrucken, um mit der gedruckten Paste die gewünschten Antennenstrukturen zu realisieren. Danach wurde diese Kunststofffolie mit den aufgedruckten Antennenstrukturen an einem Fahrzeugbauteil montiert, z. B. flächig aufgeklebt. Dabei ist es erforderlich, dass die Fläche und geometrische Ausgestaltung desjenigen Bereiches des Fahrzeugteiles, an dem die Kunststofffolie angebracht werden soll, auch der Fläche bzw. geometrischen Ausgestaltung der Kunststofffolie entspricht. So ist es mit dieser bekannten Ausgestaltung nicht möglich, die flächige Kunststofffolie an einem komplex gestalteten Bauteil des Fahrzeuges anzubringen.

Weiterhin ist aus der DE 10 2005 034 085.7 ein Verfahren zur Herstellung einer Antenneneinrichtung und eine danach hergestellte Antenneneinrichtung bekannt, bei dem in analoger Weise, wie oben beschrieben, eine Kunststofffolie mit Antennenstrukturen versehen wird. Diese derart vorbereitete Kunststofffolie wird dann in eine Form, vorzugsweise eine Spritzgußform, eingelegt und die Form mit weiterem Kunststoffmaterial gefüllt, wobei danach das fertige Fahrzeugbauteil der Form entnommen werden kann und es schon die Antenneneinrichtung enthält. Auch hier ist der Nachteil gegeben, dass der Bereich der Form, in den die Kunststofffolie eingelegt wird, weitestgehend flächig, allenfalls mit einer leichten Wölbung, ausgestaltet sein muss, damit sich die Kunststofffolie beim Füllen der Form mit Kunststoffmaterial großflächig mit diesem eingefüllten Material (z. B. eingespritztem Kunststoff) verbindet. Auch hier ist es nicht möglich, komplex gestaltete Fahrzeugbauteile, die z. B. Vertiefungen, Stege, Wölbungen mit engen Radien und dergleichen aufweisen, herzustellen.

Der Erfindung liegt daher die Aufgabe zugrunde, ein Verfahren bereitzustellen, das es ermöglicht, Fahrzeugbauteile mit komplexen Strukturen bzw. komplexen geometrischen Gestaltungen herzustellen, die mit einer Antenneneinrichtung versehen werden können oder die schon mit ihrer Herstellung eine Antenneneinrichtung umfassen.

Zur Lösung dieser Aufgabe ist folgendes Verfahren vorgesehen:

Erfindungsgemäß besteht die zunächst flächige Kunststofffolie aus einem verformbaren Material besteht und wird nach dem Bedrucken einer Umformung unterzogen, so dass die vorbereitete Kunststofffolie zusammen mit den Antennenstrukturen derart dauerhaft und plastisch verformt wird, dass nach dieser Verformung eine dreidimensional Form erreicht wird, die dem Einbauraum des Fahrzeugbauteiles entspricht.

Basis ist wieder eine Kunststofffolie, auf der elektrisch leitfähige Strukturen angeordnet werden. Auch hier kommt wieder in Betracht, dass die elektrisch leitfähigen Strukturen eine elektrisch leitfähige Paste sind, die auf die Kunststofffolie aufgedruckt wird. Die Kunststofffolie und vorzugsweise auch die elektrisch leitfähigen Strukturen, die aufgebracht worden sind, haben die Materialeigenschaft, dass sie sich dauerhaft umformen lassen. Hier kommt zum Beispiel in Betracht, dass die Kunststofffolie aus einem thermoplastisch verformbaren Material besteht und einer Wärmeeinwirkung unterzogen wird, so dass die vorbereitete Kunststofffolie mit Antennenstrukturen derart dauerhaft plastisch verformt wird, dass nach dieser Verformung eine Form erreicht wird, die dem Einbauraum des Fahrzeugbauteiles entspricht. Das Verfahren kann beispielsweise ein Tiefziehverfahren sein, bei dem die Kunststofffolie unter Wärmeeinwirkung auf einer Positivform, die dem Negativ des Fahrzeugbauteiles entspricht (oder umgekehrt) umgeformt wird, so dass diese nach dem Umformen eine geometrische Form erhalten hat, die dem Einbauraum am Fahrzeugbauteil entspricht. Danach kann diese Antenneneinrichtung, nachdem z. B. Ränder entfernt und Kontaktpunkte oder Steckverbinder angebracht worden sind, mit dem Fahrzeugbauteil dauerhaft (z. B. durch Verkleben) oder lösbar verbunden werden.

Ein weiterer wichtiger Aspekt der Erfindung ist im Folgenden darin zu sehen, dass die elektrisch leitfähigen Strukturen, die auf die flächige Kunststofffolie aufgebracht werden, nicht diejenige Struktur aufweisen, die sie nach dem Umformen aufweisen und somit die Antennenstrukturen erst nach dem Umformen der Kunststofffolie in ihre endgültige geometrische Ausgestaltung gebildet werden. Das bedeutet mit anderen Worten, dass zum Beispiel vor dem Umformen die elektrisch leitfähigen Strukturen noch überhaupt nicht als Antennenstruktur wirken können und erst dann als Antennenstruktur wirken, wenn sie zusammen mit der Trägerfolie umgeformt worden sind. Dies hängt aber im Wesentlichen von dem Verformungsgrad ab, so dass es selbstverständlich auch denkbar ist, dass die auf die Kunststofffolie vor dem Verformen aufgebrachten Strukturen schon als Antennenstrukturen wirken können (aber nicht müssen) und ihre optimale Wirkung als Antennenstruktur erst nach dem Umformen der Kunststofffolie in ihre endgültige geometrische komplexe Form erreichen. Dabei ist selbstverständlich bei der Materialwahl für die elektrisch leitfähigen Strukturen darauf zu achten, dass sich beim Umformen dieses Material ebenfalls mit umformen lässt und dabei keine Risse entstehen, die die Funktion der späteren Antennenstruktur beeinträchtigen können.

Insgesamt liegt der Erfindung somit die Idee zugrunde, aus einem zweidimensionalen (d. h. flächigen) Gebilde aus Träger und dort aufgebrachten elektrisch leitfähigen Strukturen, durch einen Umformvorgang ein dreidimensionales Gebilde zu machen, das nach dem Umformen in seine endgültige Form, die der Form des Fahrzeugbauteiles entspricht, gebracht und am Fahrzeugbauteil angebracht wird, wobei auf jeden Fall nach dem Umformvorgang die elektrisch leitfähigen und mit umgeformten Strukturen die Antennenstruktur bildet.

## Patentansprüche

1. Verfahren zur Herstellung einer Antenneneinrichtung für Fahrzeuge, wobei eine Kunststofffolie mit einer elektrisch leitfähigen Paste bedruckt wird, um mit der gedruckten Paste Antennenstrukturen zu realisieren, wobei nach der Herstellung die Antenneneinrichtung in einen dafür vorgesehenen Einbauraum eines Fahrzeugbauteiles eingebaut wird, **dadurch gekennzeichnet, dass** die zunächst flächige Kunststofffolie aus einem verformbaren Material besteht und nach dem Bedrucken einer Umformung unterzogen wird, so dass die vorbereitete Kunststofffolie zusammen mit den Antennenstrukturen derart dauerhaft und plastisch verformt wird, dass nach dieser Verformung eine dreidimensional Form erreicht wird, die dem Einbauraum des Fahrzeugbauteiles entspricht.

2. Verfahren zur Herstellung einer Antenneneinrichtung für Fahrzeuge nach Anspruch 1, **dadurch gekennzeichnet, dass** die elektrisch leitfähigen Strukturen, die auf die flächige Kunststofffolie aufgebracht werden, nicht diejenige Struktur aufweisen, die sie nach dem Umformen aufweisen und somit die Antennenstrukturen erst nach dem Umformen der Kunststofffolie in ihre endgültige geometrische Ausgestaltung gebildet werden.

3. Verfahren zur Herstellung einer Antenneneinrichtung für Fahrzeuge nach Anspruch 1 oder 2, **dadurch gekennzeichnet, dass** die Kunststofffolie aus einem thermoplastisch verformbaren Material besteht und nach dem Bedrucken einer Wärmeeinwirkung unterzogen wird

4. Verfahren zur Herstellung einer Antenneneinrichtung für Fahrzeuge nach Anspruch 1, 2 oder 3, **dadurch gekennzeichnet, dass** die Kunststofffolie in einem Siebdruckverfahren mit der Paste bedruckt wird.

5. Verfahren zur Herstellung einer Antenneneinrichtung für Fahrzeuge nach einem der Ansprüche 1 bis 4, **dadurch gekennzeichnet, dass** die Umformung der Kunststofffolie in einem Tiefziehverfahren umgeformt wird, bei dem die Kunststofffolie unter Wärmeeinwirkung auf einer Positivform, die dem Negativ des Fahrzeugbauteiles entspricht (oder umgekehrt), umgeformt wird, so dass diese nach dem Umformen eine geometrische Form erhalten hat, die dem Einbauraum am Fahrzeugbauteil entspricht

6. Verfahren zur Herstellung einer Antenneneinrichtung für Fahrzeuge nach einem der Ansprüche 1 bis 5, **dadurch gekennzeichnet, dass** die Antenneneinrichtung mit dem Fahrzeugbauteil dauerhaft oder lösbar verbunden wird, nachdem überstehende Ränder an der Kunststofffolie entfernt und Kontaktpunkte oder Steckverbinder angebracht worden sind.
